# EUROPÄISCHE PATENTANMELDUNG

(11) **EP 0 744 789 A1**
(43) Veröffentlichungstag der Anmeldung: **27.11.1996**
(21) Anmeldenummer: 96102633.3
(22) Anmeldetag: 22.02.1996
(51) Int. Cl.: H01R 9/07

(54) **Elektrische Verbindung von einander örtlich getrennten Bauteilen**

(30) Priorität: 24.05.1995 DE 29508661 U
(71) Anmelder: ROBERT BOSCH GMBH, 70442 Stuttgart (DE)
(72) Erfinder: Hofmeister, Werner, Dipl.-Ing., D-75417 Muehlacker (DE); Karr, Dieter, Dipl.-Physiker, D-75233 Tiefenbronn (DE); Buss, Heiko, D-74232 Abstatt (DE); Schimitzek, Ralph, Dipl.-Ing., D-74182 Obersulm/Sulzbach (DE)

(57) **Zusammenfassung**

Es wird eine elektrische Verbindung von einander örtlich getrennten Bauteilen, speziell ein Kabelanschluß für elektronische Steuergeräte vorgeschlagen, bei dem sowohl ein Steuergerät (1) als auch ein Kabelschwanz (16) eines Kabelbaumes (21) mit Flexfolien (4 und 9) ausgerüstet sind. Eine zungenartige Flexfolie (4) des Steuergerätes (1) ist mit verzinnten Lands (5) versehen. Die zungenartige Flexfolie (4) und die bandförmige Flexfolie (9) des Kabelschwanzes (16) werden mittels einer Fixierhilfe (8) kontaktgebend aufeinandergelegt und dann zur bleibenden Kontaktierung einem vorzugsweise mittels Wärme und Druck erzeugen Schmelzvorgang unterworfen. Eine mechanische Verbindung wird mit Hilfe eines Aufschmelzklebers erreicht.

Die Verbindung ist bestimmt für den Einsatz im Automobilbau, beispielsweise für Ansaugmodule einer Brennkraftmaschine oder für Magnetventile von ABS- und/oder ASR-Einrichtungen.

## Beschreibung

### Stand der Technik

Die Erfindung bezieht sich auf eine elektrische Verbindung von einander örtlich getrennten Bauteilen nach der Gattung des Hauptanspruchs und speziell auf einen Kabelanschluß für elektronische Steuergeräte. Ein derartiger Kabelanschluß ist, wie nachfolgend ausgeführt, bekannt.

In Kraftfahrzeugen werden heute eine Vielzahl von Steuergeräten verwendet, die mit elektronischen Schaltelementen bestückt sind und von Sensoren Signale erhalten und verarbeiten und an nachgeschaltete Schaltgeräte wie Ansaugmodule für die Steuerung des Motors oder wie Magnetventile in Blockierschutz- und Antriebsschlupfschutz-einrichtungen weitergeben. Derartige Steuergeräte sind mit Steckverbindungen ausgerüstet, über die Kabelanschlüsse herstellbar sind. Diese Steckverbindungen werden nach dem Einbau der Steuergeräte gesteckt.

In der Praxis hat sich gezeigt, daß solche Steckverbindungen beim rauhen Betrieb auf einem Kraftfahrzeug nicht genügend rüttelfest sind, so daß sich die gesteckten Verbindungen zum Teil wieder lösen, was zum Ausfall der Ansteuerung führt.

Der Erfindung liegt die Aufgabe zugrunde, diese Nachteile zu vermeiden und einen Kabelanschluß zu schaffen, der einfach herzustellen ist und der so rüttelfest ist, daß er sich mit Sicherheit nicht löst, so daß kein Ausfall von Ansteuerungen zu befürchten ist.

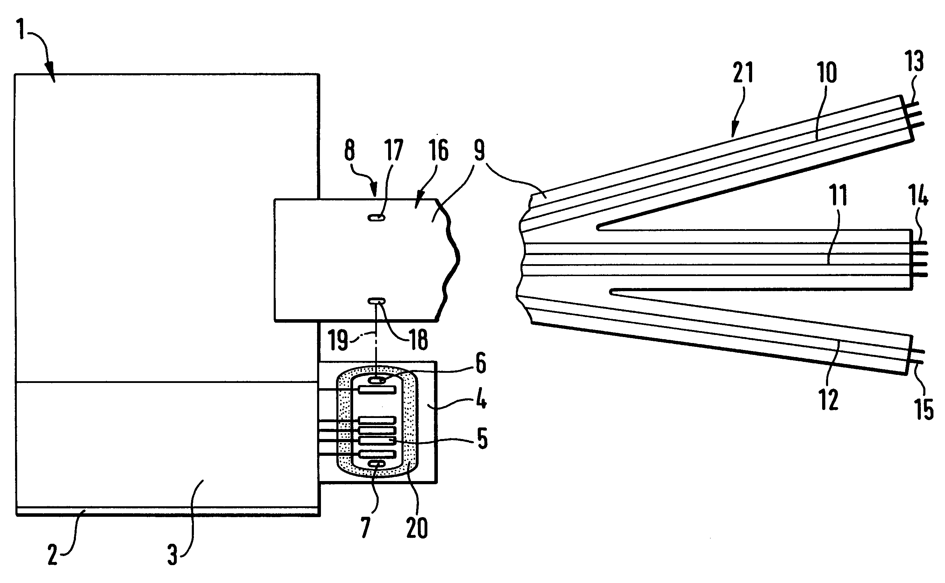

Diese Aufgabe wird gemäß der Erfindung bei der eingangs genannten elektrischen Verbindung von einander örtlich getrennten Bauteilen gelöst durch die kennzeichnenden Merkmale des Hauptanspruchs. Vorteilhafte Weiterbildungen der Verbindung nach dem Anspruch 1 ergeben sich aus den Merkmalen der Unteransprüche, aus der Beschreibung und aus der Zeichnung.

### Zeichnung

Ein Ausführungsbeispiel der Erfindung ist in der Zeichnung in der Figur schematisiert dargestellt und in der nachfolgenden Beschreibung näher erläutert.

### Beschreibung des Ausführungsbeispiels

Ein mit elektronischen Bauelementen bestücktes Bauteil, das als ein Steuergerät 1 ausgeführt ist, ist in Flexfolientechnik auf einem rechteckigen, plattenförmigen Metallträger 2 mit diskreter Schaltung aufgebaut, die in SMD- oder in Hybrid-Technik auf eine Folie 3 gebondet ist. Das Steuergerät 1 ist in nicht dargestellter Weise mittels Isolierstoff, beispielsweise PUR-Schaum abgedichtet.

Aus dem Steuergerät 1 ragen verschiedene zungenartige Flexfolien 4 heraus, auf denen nebeneinander verzinnte Lands 5 als Anschlußstellen angeordnet sind, die elektrisch an das Steuergerät angeschlossen sind. Außerdem hat jede zungenartige Flexfolie 4 zwei Durchbrüche 6 und 7, die als Fixierhilfe 8 dienen.

Eine bandförmige Flexfolie 9 bildet mit mehreren Leitern 10, 11, 12 einen Kabelbaum 21 und ist einerseits mit angeschlagenen Steckern 13, 14, 15 als Kontaktiermittel und andererseits mit einem Kabelschwanz 16 ausgerüstet. Der Kabelschwanz 16 hat, gerade so wie die zungenartige Flexfolie 4, zwei Durchbrüche 17 und 18, die zur Fixierhilfe 8 gehören.

Zur Verbindung des Kabelschwanzes 16 mit der zungenartigen Flexfolie 4 des Steuergerätes 1 werden die Folienenden mit der Fixierhilfe 8 genau aufeinandergelegt. Dabei wird die elektrische Verbindung im Bereich einer sogenannten Schnittstelle 19 durch Berührungskontakt hergestellt. Um eine solche Verbindung, die elektrische und/oder die der Flexfolien, dauerhaft zu machen, können die beiden Flexfolien 4 und 9 mittels Wärme und Druck einem Schmelzvorgang mit Verschweißung der Folien und gegebenenfalls einer Verlötung der Kontaktstellen unterworfen werden. Auch eine Verschmelzung mit Hilfe von Ultraschall oder mit Reibschweißen ist möglich. Schließlich ist auch die Verwendung eines Klebers oder ähnlichem denkbar. Eine zusätzliche mechanische Verbindung der beiden Flexfolien 4 und 9 wird mit Hilfe eines, vorzugsweise einen in sich geschlossenen Ring 20 bildenden Aufschmelzklebers, der den Bereich der elektrischen Verbindungen umschließt, erreicht, letzteres mit dem Vorteil, daß durch den geschlossenen Ring 20 gleichzeitig eine Dichtung zum Schutz der elektrischen Verbindungen geschaffen wird.

Bei der Herstellung der erfindungsgemäßen Verbindung wird zuerst das Steuergerät 1 gefertigt. Letzter Arbeitsgang ist dann die Verbindung der beiden Flexfolien 4 und 9 am Steuergerät 1 und am Kabelschwanz 16. Die am anderen Ende des Kabelbaumes 21 vorgesehenen Stecker 13, 14 und 15 oder Verbindungsbereiche, die auch aus Lötverbindungen bestehen können, können samt Folie umschäumt werden, um hier ebenfalls Dichtheit zu erreichen.

Es ist zu erkennen, daß sich die erfindungsgemäße Verbindung durch den Fortfall von Steckverbindungen auszeichnet. Die Verbindungstechnik des Kabelschwanzes 16 mit dem Steuergerät 1 erlaubt es, daß die Leitungen erst nach vollständiger Montage und Prüfung des Steuergeräts 1 angeschlagen werden brauchen. Damit ist erreicht, daß trotz der Verwendung eines Kabelschwanzes 16 als Teil eines Kabelbaumes 21 keine Nachteile in der Fertigung des Steuergeräts 1 entstehen. Außerdem ergibt sich der Vorteil, daß bei unterschiedlichen Applikationen der Aufbau des Steuergerätes 1 gleich bleiben kann und nur der Kabelschwanz 16 an den jeweiligen Anwendungsfall angepaßt werden muß. Schließlich hat die erfindungsgemäße Ausführung den Vorteil absoluter Dichtheit.

## Patentansprüche

1. Elektrische Verbindung von einander örtlich getrennten Bauteilen (1), insbesondere in Kraftfahrzeugen, mit einem mehrere Leiter (10, 11, 12) aufweisenden Verbindungsteil (21), dadurch gekennzeichnet, daß das Verbindungsteil (21) einen Kabelschwanz (16) mit einer bandförmigen Flexfolie (9) hat und daß wenigstens eines der Bauteile (1) mindestens ein Anschluß auf einer zungenartigen Flexfolie (4) aufweist und daß die bandförmige Flexfolie (9) mit freiliegenden Verbindungsstellen der Leiter (10, 11, 12) und der Anschluß der zungenartigen Flexfolie (4) des Bauteils (1), zusammen eine Schnittstelle (19) bildend, kontaktierend miteinander verbindbar sind.

2. Verbindung nach Anspruch 1, dadurch gekennzeichnet, daß die Verbindungsstellen der Leiter (10, 11, 12) der bandförmigen Flexfolie (9) und der Anschluß der zungenartigen Flexfolie (4) als verzinnte Lands (5) ausgebildet sind.

3. Verbindung nach Anspruch 1 oder 2, dadurch gekennzeichnet, daß zur Kontaktierung der Leiter (10, 11, 12) und des Anschlusses miteinander und zur Verbindung der beiden Flexfolien (4 und 9) miteinander ein Schmelzvorgang mit Wärme und Druck angewendet wird.

4. Verbindung nach Anspruch 1 oder 2, dadurch gekennzeichnet, daß zur kontaktierenden Verbindung der beiden Flexfolien (4 und 9) ein Schmelzvorgang mit Ultraschall angewendet ist.

5. Verbindung nach Anspruch 1 oder 2, dadurch gekennzeichnet, daß zur kontaktierenden Verbindung der beiden Flexfolien (4 und 9) ein Kleber angewendet ist.

6. Verbindung nach einem der Ansprüche 1 bis 5, dadurch gekennzeichnet, daß zwischen den beiden Flexfolien (4 und 9) eine Fixierhilfe (8) in Form von Durchbrüchen (6 und 7; 17 und 18) vorgesehen ist.

7. Kabelanschluß nach einem der Ansprüche 1 bis 6, dadurch gekennzeichnet, daß zusätzlich zu der kontaktierenden Verbindung zwischen den Flexfolien (4 und 9) eine mechanische Verbindung durch einen Aufschmelzkleber geschaffen ist.

8. Kabelanschluß nach Anspruch 7, dadurch gekennzeichnet, daß der Aufschmelzkleber als in sich geschlossener Ring (20) ausgebildet ist.
